# EUROPÄISCHE PATENTSCHRIFT

(11) **EP 2 499 085 B1**
(45) Veröffentlichungstag und Bekanntmachung des Hinweises auf die Patenterteilung: **28.08.2013**
(21) Anmeldenummer: 10757200.0
(22) Anmeldetag: 23.09.2010
(51) Int. Cl.: B81C 1/00

(54) **MIKROMECHANISCHES VERFAHREN UND ENTSPRECHENDE ANORDNUNG ZUM BONDEN VON HALBLEITERSUBSTRATEN SOWIE ENTSPRECHENDER GEBONDETER HALBLEITERCHIP**
MICROMECHANICAL METHOD AND CORRESPONDING ASSEMBLY FOR BONDING SEMICONDUCTOR SUBSTRATES AND CORRESPONDINGLY BONDED SEMICONDUCTOR CHIP
PROCÉDÉ MICROMÉCANIQUE ET AGENCEMENT CORRESPONDANT POUR L'ASSEMBLAGE DE SUBSTRATS SEMICONDUCTEURS, AINSI QUE PUCE SEMICONDUCTRICE ASSEMBLÉE CORRESPONDANTE

(30) Priorität: 13.11.2009 DE 102009046687
(43) Veröffentlichungstag der Anmeldung: 19.09.2012
(73) Patentinhaber: Robert Bosch GmbH, 70442 Stuttgart (DE)
(72) Erfinder: TRAUTMANN, Achim, 71229 Leonberg (DE); REICHENBACH, Ralf, 73732 Esslingen (DE)
(86) Internationale Anmeldenummer: PCT/EP2010/064009
(87) Internationale Veröffentlichungsnummer: WO 2011/057850

(56) Entgegenhaltungen:
- EP-A1- 1 720 204
- EP-A1- 1 921 662
- US-A1- 2007 048 898
- US-A1- 2008 067 652

## Beschreibung

### Stand der Technik

Die vorliegende Erfindung betrifft ein mikromechanisches Verfahren und eine entsprechende Anordnung zum Bonden von Halbleitersubstraten sowie einen entsprechenden gebondeten Halbleiterchip.

Obwohl auf beliebige mikromechanische Bauelemente und Strukturen, insbesondere Sensoren und Aktuatoren, anwendbar, werden die vorliegende Erfindung sowie die ihr zugrundeliegende Problematik in Bezug auf einen in der Technologie der Silizium-Oberflächenmikromechanik herstellbaren mikromechanischen Sensor erläutert.

Mikromechanische Substratverbindungen, z.B. Wafer-Wafer-Bond-Verbindungen, werden üblicher Weise durch eutektische Legierungen mit zwei oder mehreren festen Bondmaterialien bzw. Legierungskomponenten als Bestandteilen realisiert. Derartige eutektische Legierungen haben einen eindeutig bestimmbaren Schmelzpunkt. Andere Mischungsverhältnisse mit denselben Legierungskomponenten weisen dagegen einen Schmelz- bzw. Erstarrungsbereich auf, in dem neben der Schmelze auch eine feste Phase vorliegt. Der Schmelzpunkt der eutektischen Legierung ist zudem der niedrigste aller Mischungen aus denselben Bestandteilen.

Während des Bondprozesses muss eine minimal erforderliche Bondkraft aufgebracht werden, um die Bondlegierungen auf Waferlevel in Kontakt zu bringen. Dadurch kommt es zum Verlaufen der flüssigen eutektischen Phase. Dabei kann es passieren, dass die flüssige eutektische Phase unkontrolliert in MEMS-Funktionsbereiche fließt. Um ein derartiges Verfließen zu minimieren bzw. zu verhindern, kann beispielsweise ein recht breiter Stoppgraben jeweils innen und außen um den Bondrahmen vorgesehen werden, wodurch ein erhöhter Flächenbedarf auf Chiplevel vorgehalten werden muss.

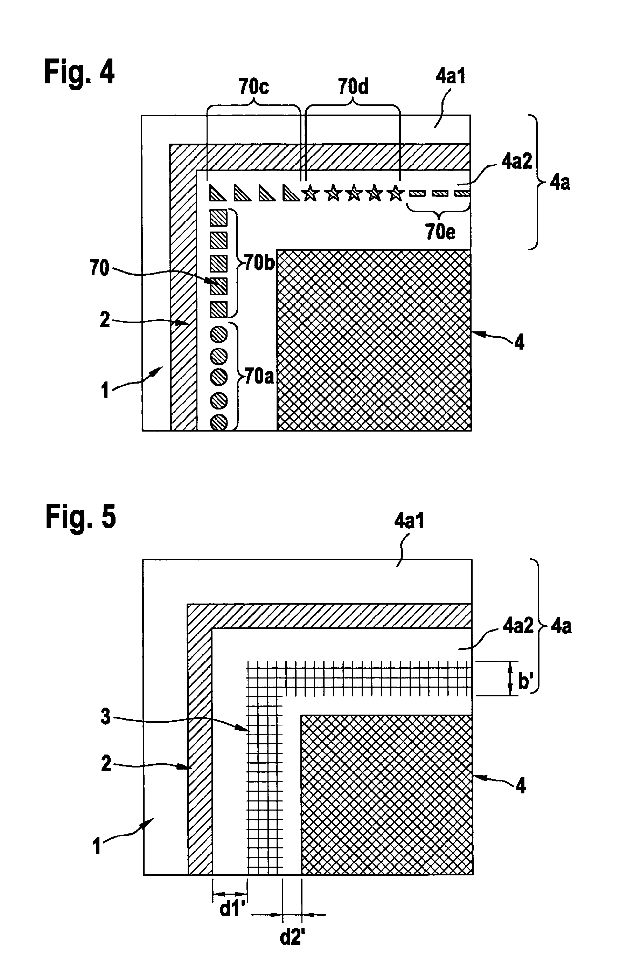

Fig. 5 ist eine schematische teilweise Draufsicht auf einen Chipbereich einer beispielhaften Anordnung zum Bonden von Halbleitersubstraten.

Der mikromechanische Sensorchip 1, welcher einen aktiven Funktionsbereich 4 und einen passiven Randbereich 4a aufweist. Im Randbereich 4a vorgesehen ist ein Bonrahmen 2 mit einer aufgebrachten eutektischen Bondlegierung, beispielsweise Al-Ge, der den Randbereich 4a in einen Innenbereich 4a2, der vom Bondrahmen umgeben ist, und einen Außenbereich 4a1 aufteilt. Im Innenbereich 4a2 zwischen Bondrahmen 2 und Funktionsbereich 4 des Sensorchips 1 liegt ein Stoppgraben 3, der verhindern soll, dass beim Bondvorgang aus dem Bereich des Bondrahmens 2 Schmelze in den Funktionsbereich 4 fließt. Durch die Verwendung des Stoppgrabens 3 wird also der Teil der beim Bondvorgang verlaufenden Schmelze aufgefangen. Ty-pische Dimensionen eines derartigen Stoppgrabens 3 liegen zwischen 20 und 50 µm in der Breite b. Dieser Stoppgraben 3 benötigt zusätzlich sowohl einen Mindest-abstand d1 zu dem Bondrahmen 2 wie auch einen Mindestabstand d2 zum aktiven Funktionsbereich 4. Gerade bei immer kleiner werdenden Sensorchips ist hierdurch ein nicht erheblicher Flächenbedarf nötig.

Aus der WO 2005/008772 A2 ist ein elektronisches Bauteil mit einem Halbleiterchip und einem Flachleiterrahmen bekannt, der zur Belotung des elektronischen Bauteils ein Metallbeschichtungsmuster auf seiner Unterseite aufweist. Dieses Metallbeschichtungsmuster weist Benetzungsbereiche auf, die mit Lotmaterial benetzt werden können, und Antibenetzungsbereiche, die nicht mit Lotmaterial benetzbar sind, wobei das elektronische Bauteil auf den Benetzungsbereichen auf der Unterseite Lotdepots aufweist.

Die US 2007/0048898 A1 offenbart ein hermetisch abgedichtetes System auf Wafer-Ebene mit einer Metalllegierung mit einem erhöhten Teil.
Die US2008/067652 A1 offenbart ein Verfahren zum Bonden von Halbleiterchips wobei auf einer Chiphälfte ein Bondrahmen aus einer eutektischen Legierung aufgebracht ist. Ein Eindringen der Schmelze in den Funktionsbereich des Halbleiterchips wird durch einen innenliegenden Stopprahmen verhindert.

### Vorteile der Erfindung

Die erfindungsgemäße Anordnung nach Anspruch 1 bzw. das mikromechanische Verfahren zum Bonden von Halbleitersubstraten nach Anspruch 8 bzw. der entsprechende gebondete Halbleiterchip nach Anspruch 9 weisen den Vorteil auf, dass durch Einbringen eines ver-hältnismäßige kleinen strukturierten Stopprahmens aus mindestens einer der Legierungskomponenten, zumindest innerhalb und vorzugsweise innerhalb und außerhalb des eigentlichen Bondrahmens, die verfließende Schmelze aufgehalten wird.

Der Stopprahmen aus mindestens einer der Legierungskomponenten kann unabhängig von den eingesetzten Lithographie- und Strukturierungsprozessen zwischen 0,1 und 50 µm, vorzugsweise zwischen 1 und 20 µm und besonders vorzugsweise zwischen 5 und 10 µm breit ausgeführt werden und stellt somit einen wesentlich niedrigeren Flächenbedarf im Vergleich zu den Stoppgräben dar. Der Abstand zu dem Bondrahmen und zu dem Funktionsbereich des Sensors kann im Vergleich zu den Stoppgräben deutlich geringer ausgeführt werden, vorzugsweise zwischen 1 und 20 µm und besonders vorzugsweise zwischen 5 und 10 µm.

Die der vorliegenden Erfindung zugrunde liegende Idee besteht im Vorsehen einer Kompensationsstruktur aus mindestens einer der Legierungsmaterialien zur in situ Verfestigung der flüssigen Phase. Der zugrunde liegende Mechanismus liegt darin, dass die Schmelze bei Kontakt mit den zusätzlich bereitgestellten Material der Legierungskomponente erstarrt, da die neue Zusammensetzung einen höheren Schmelzpunkt aufweist, z.B. die eutektische Zusammensetzung, nicht mehr gegeben ist, und somit kein weiteres Verfließen möglich ist.

Vorzugsweise besteht die Bondlegierung aus einer der folgenden Mischungen: Au-Si, Al-Ge, Cu-Sn, Au-In sowie Legierungen aus den jeweiligen Einzelmaterialien in Betracht, wie z. B. AlSiCu-GE, AlSi-Ge oder AlCu-Ge. Prinzipiell denkbar sind alle in der Mikromechanik verwendbaren Legierungspartner.

Besonders bevorzugt sind Legierungspartner, deren Phasendiagramme eine eutektische Legierung vorsehen. Eine beispielhafte Legierung ist Al-Ge. Die Schmelztemperaturen der beiden Bondmaterialien sind für reines Aluminium 660°C und reines Germanium 938°C. Die Schmelztemperatur im eutektischen Punkt liegt bei 420°C. Die zur Bondung nötige kritische Bondtemperatur ist beim eutektischen Bonden abhängig von der Mischung der verwendeten Materialien. Im Idealfall bildet sich eine flüssige Phase bei der Schmelztemperatur im eutektischen Punkt aus. Im beispielhaften Falle der AlGe-Legierung liegt die tatsächliche Bondtemperatur üblicher Weise im Bereich 420°C bis 450°C.

Des Weiteren wird durch die erfindungsgemäßen Stoppstrukturen auch keine unnötig hohe Topographie, wie z. B. durch einen Stoppgraben, erzeugt.

In den Unteransprüchen finden sich vorteilhafte Weiterbildungen und Verbesserungen des jeweiligen Gegenstandes der Erfindung.

### Zeichnungen

Ausführungsbeispiele der Erfindung sind in der Zeichnung dargestellt und in der nachfolgenden Beschreibung näher erläutert.

Es zeigen:

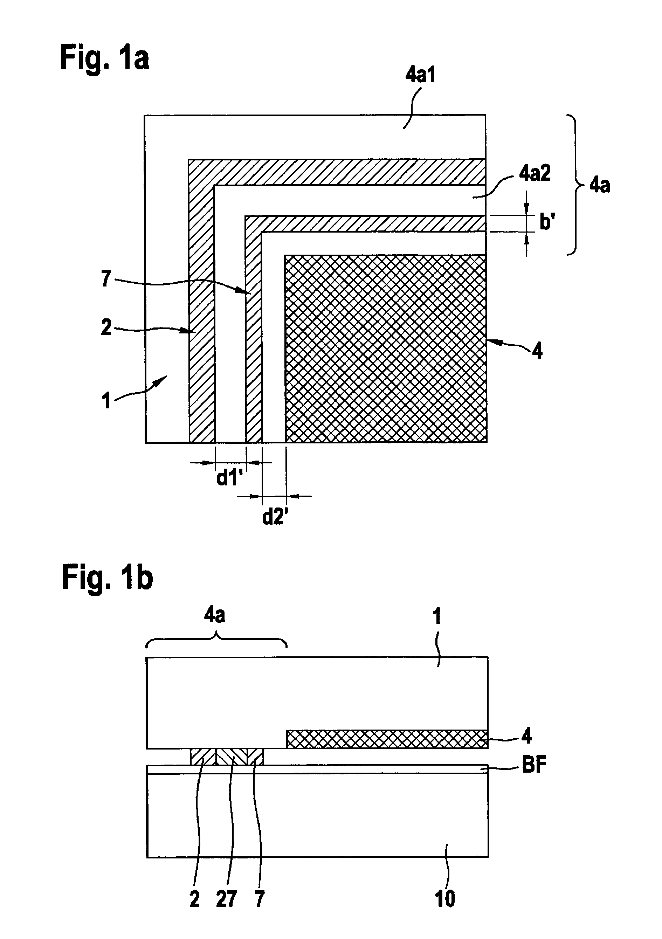

- Fig. 1a: eine schematische teilweise Draufsicht auf einen Chipbereich einer Anordnung zum Bonden von Halbleitersubstraten gemäß einer ersten Ausführungsform der vorliegenden Erfindung;
- Fig. 1 b: eine schematische teilweise Querschnittsansicht eines gebondeten Chips gefertigt aus der Anordnung zum Bonden von Halbleitersubstraten gemäß der ersten Ausführungsform der vorliegenden Erfindung;
- Fig. 2: eine schematische teilweise Draufsicht auf einen Chipbereich einer Anordnung zum Bonden von Halbleitersubstraten gemäß einer zweiten Ausführungsform der vorliegenden Erfindung;
- Fig. 3: eine schematische teilweise Draufsicht auf einen Chipbereich einer Anordnung zum Bonden von Halbleitersubstraten gemäß einer dritten Ausführungsform der vorliegenden Erfindung;
- Fig. 4: eine schematische teilweise Draufsicht auf einen Chipbereich einer Anordnung zum Bonden von Halbleitersubstraten gemäß einer vierten Ausführungsform der vorliegenden Erfindung; und
- Fig. 5: eine schematische teilweise Draufsicht auf einen Chipbereich einer beispielhaften Anordnung zum Bonden von Halbleitersubstraten.

### Beschreibung der Ausführungsbeispiele

In den Figuren bezeichnen gleiche Bezugszeichen gleiche oder funktionsgleiche Bestandteile.

Fig. 1a ist eine schematische teilweise Draufsicht auf einen Chipbereich einer Anordnung zum Bonden von Halbleitersubstraten gemäß einer ersten Ausführungsform der vorliegenden Erfindung.

Der mikromechanische Sensorchip 1, welcher einen aktiven Funktionsbereich 4 und einen passiven Randbereich 4a aufweist. Im Randbereich 4a vorgesehen ist ein Bondrahmen 2 mit einer aufgebrachten eutektischen Bondlegierung, beispielsweise Al-Ge, der den Randbereich 4a in einen Innenbereich 4a2, der vom Bondrahmen umgeben ist, und einen Außenbereich 4a1 aufteilt. Im Innenbereich 4a2 zwischen Bondrahmen 2 und Funktionsbereich 4 des Sensorchips 1 ist ein Stopprahmen 7 angeordnet, welcher aus einer nicht-eutektischen Legierung aus Al und Ge besteht, also entweder einen höheren Ge-Gehalt oder einen höheren Al-Gehalt (bis hin zur jeweiligen reinen Legierungskomponente) als die entsprechende eutektische Legierung aufweist.

Dieser zusätzlich vorgesehene Stopprahmen 7 führt bei Berührung mit der vom Bondrahmen 2 ausgehenden Fließbewegung der entstandenen eutektischen Schmelze zu einer Änderung der Löslichkeit der Bondlegierung und verändert die Materialzusammensetzung der Schmelze derart, dass die Schmelze instantan erstarrt und nicht weiter fließen kann.

Der Stopprahmen 7 kann unabhängig von den eingesetzten Lithographie- und Strukturierungsprozessen zwischen 0,1 und 50 µm, vorzugsweise zwischen 1 und 20 µm und besonders vorzugsweise zwischen 5 und 10 µm breit ausgeführt werden und stellt somit einen wesentlich niedrigeren Flächenbedarf im Vergleich zu den Stoppgräben dar, was in Fig. 1a als Breite b' bezeichnet ist. Der Abstand d1' zum Bondrahmen und der Abstand d2' zum Funktionsbereich des Sensors kann im Vergleich zu den oben erwähnten Stoppgräben deutlich geringer ausgeführt werden, vorzugsweise zwischen 1 und 20 µm und besonders vorzugsweise zwischen 5 und 10 µm.

Fig. 1 b ist eine schematische teilweise Querschnittsansicht eines gebondeten Chips gefertigt aus der Anordnung zum Bonden von Halbleitersubstraten gemäß der ersten Ausführungsform der vorliegenden Erfindung.

Der gebondete Halbleiterchip weist eine erste Chiphälfte 1 mit einem Chip gemäß Fig. 1 und weiterhin eine zweite Chiphälfte 10 auf, welche eine Bondfläche BF aufweist, auf die der Bondrahmen 2 gebondet ist. Es gibt einen Bereich 7 erstarrter Bondlegierung, der zwischen dem Bondrahmen 2 und Stopprahmen 7 verläuft, in dem der Stopprahmen 7 die beim Bondvorgang verlaufende Schmelze abgefangen hat.

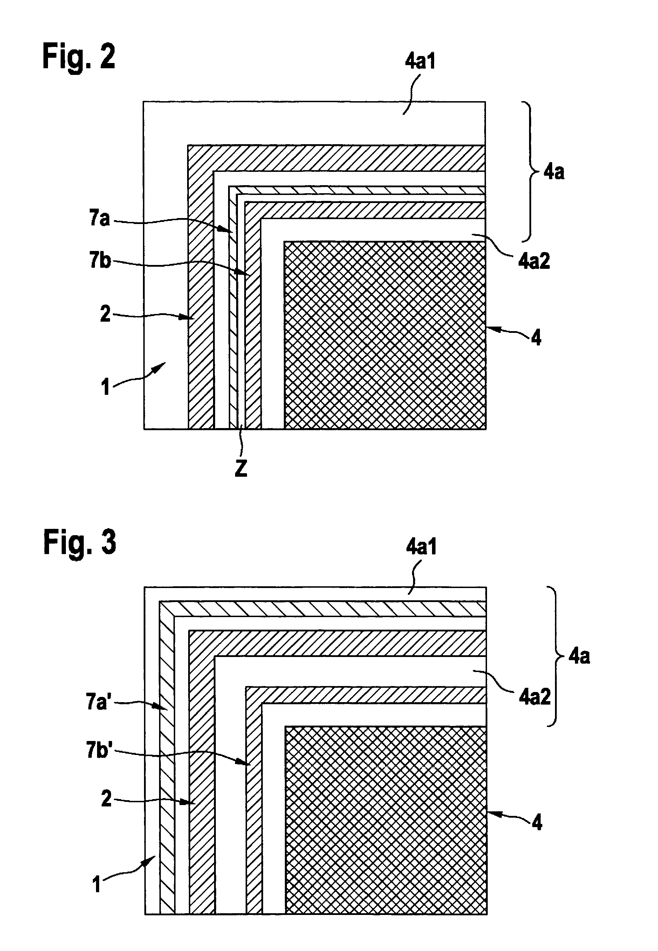

Fig. 2 ist eine schematische teilweise Draufsicht auf einen Chipbereich einer Anordnung zum Bonden von Halbleitersubstraten gemäß einer zweiten Ausführungsform der vorliegenden Erfindung.

Bei der zweiten Ausführungsform gemäß Figur 2 ist ein doppelter Stopprahmen 7a, 7b mit einem zwischen den beiden Stopprahmen 7a, 7b liegenden Zwischenraum Z vorgesehen. Bei dieser zweiten Ausführungsform lässt sich zusätzlich zur Veränderung des Mischungsverhältnisses der Legierung aus dem eutektischen Bereich heraus, die zwischen den beiden parallel geführten Stopprahmen 7a, 7b ausbildenden Kapillarwirkung im Zwischenraum Z nutzen. Durch diese Kapillarwirkung können sich lokal auftretende größere Mengen einer eutektischen Schmelze zügig entlang der Stopprahmen 7a, 7b über den Zwischenraum Z verteilen. Diese zügige Verteilung sorgt für ein reichliches Kontaktangebot mit dem Material der Stopprahmen, was das Erstarren beschleunigt, um so ein "Überlaufen" an einer stark mit eutektischer Schmelze beaufschlagten Stelle noch effektiver verhindern zu können.

Ansonsten entspricht die zweite Ausführungsform der ersten Ausführungsform. Fig. 3 ist eine schematische teilweise Draufsicht auf einen Chipbereich einer Anordnung zum Bonden von Halbleitersubstraten gemäß einer dritten Ausführungsform der vorliegenden Erfindung.

Bei der dritten Ausführungsform gemäß Figur 3 sind sowohl außerhalb des Bondrahmens 2 als auch innerhalb des Bondrahmens 2 ein jeweiliger Stopprahmen 7a' bzw. 7b' aus einer nicht-eutektischen Legierung bzw. einer der Legierungskomponenten vorgesehen.

Ansonsten entspricht die dritte Ausführungsform der ersten und zweiten Ausführungsform.

Fig. 4 ist eine schematische teilweise Draufsicht auf einen Chipbereich einer Anordnung zum Bonden von Halbleitersubstraten gemäß einer vierten Ausführungsform der vorliegenden Erfindung.

Bei der vierten Ausführungsform gemäß Figur 4 sind Beispiele für Strukturen gegeben, welche einen diskontinuierlichen Stopprahmen bilden können, und zwar jeweils für sich bzw. kombiniert miteinander. Die Stopprahmenmuster umfassen ein Punktmuster 70a, ein Quadratmuster 70b, ein Dreiecksmuster 70c, ein Sternmuster 70d und ein Strichmuster 70e. Selbstverständlich sind beliebige andere Geometrien denkbar, wobei auf eine vergleichbare Breite wie bei einem entsprechenden kontinuierlichen Stopprahmen und einen nicht so großen Abstand d von typischerweise 1 bis 15 µm zwischen den einzelnen Strukturelementen geachtet werden sollte.

Ansonsten entspricht die vierte Ausführungsform der ersten bis dritten Ausführungsform.

Obwohl die vorliegende Erfindung vorstehend anhand bevorzugter Ausführungsbeispiele beschrieben wurde, ist sie darauf nicht beschränkt, sondern auf vielfältige Weise innerhalb des Geltungsbereiches der Erfindung modifizierbar.

Obwohl bei den obigen Ausführungsformen konkrete Muster und Legierungen angegeben wurden, ist die vorliegende Erfindung nicht darauf beschränkt, und es können selbstverständlich davon abweichende Muster und Legierungen verwendet werden, die den Effekt der Erstarrung eines überfließenden Schmelz bewirken.

Auch ist die Erfindung nicht auf eutektische Mischungen beschränkt, sondern auf alle Legierungen anwendbar, deren Schmelzpunkt sich durch Zugabe mindestens einer der Legierungskomponenten erhöhen lässt.

## Patentansprüche

1. Anordnung zum Bonden von Halbleitersubstraten mit:
einem Halbleitersubstrat mit einem Chipmuster mit einer Vielzahl von Halbleiterchips (1), welche jeweils einen Funktionsbereich (4) und einen den Funktionsbereich (4) umgebenden Randbereich (4a) aufweisen;
wobei im Randbereich (4a) beabstandet vom Funktionsbereich (4) ein Bondrahmen (2) aus einer Bondlegierung aus mindestens zwei Legierungskomponenten vorgesehen ist;
und innerhalb des vom Bondrahmen (2) umgebenen Teils (4a2) des Randbereichs (4a) zwischen dem Bondrahmen (2) und dem Funktionsbereich (4) mindestens ein Stopprahmen (7;7a;7b;7b';70) vorgesehen ist, **dadurch gekennzeichnet, dass** der Stopprahmen (7;7a;7b;7b';70) aus mindestens einer der Legierungskomponenten besteht, derart, dass bei einem Auftreffen einer Schmelze der Bondlegierung beim Bonden auf den Stopprahmen (7;7a;7b;7b';70) ein Erstarren der Bondlegierung auftritt.

2. Anordnung nach Anspruch 1, wobei zwischen dem Bondrahmen (2) und dem Funktionsbereich (4) zwei Stopprahmen (7; 7a, 7b; 7b'; 70) aus jeweils mindestens einer der Legierungskomponenten vorgesehen sind, die im Wesentlichen parallel verlaufen und einen Zwischenraum (Z) bilden.

3. Anordnung nach Anspruch 1 oder 2, wobei der Bondrahmen (70) eine Musterstruktur aus diskreten Musterelementen (70a, 70,b, 70c, 70d) mit einem jeweiligen Zwischenabstand (d) aufweist.

4. Anordnung nach einem der vorhergehenden Ansprüche, wobei im Randbereich (4a) innerhalb des vom Bondrahmen nicht umgebenen Teils (4a1) des Randbereichs (4a) mindestens ein weiterer Stopprahmen (7a') aus mindestens einer der Legierungskomponenten vorgesehen ist, der derart gestaltet ist, dass bei einem Auftreffen einer Schmelze der Bondlegierung beim Bonden auf den weiteren Stopprahmen (7a') ein Erstarren der Bondlegierung auftritt.

5. Anordnung nach einem der vorhergehenden Ansprüche, wobei die Bondlegierung eine eutektische Zusammensetzung hat.

6. Anordnung nach einem der vorhergehenden Ansprüche, wobei die Bondlegierung aus einer der folgenden Mischungen besteht: Au-Si, Al-Ge, Cu-Sn, Au-In sowie Legierungen aus den jeweiligen Einzelmaterialien in Betracht, wie z. B. AlSiCu-GE, AlSi-Ge oder AlCu-Ge.

7. Anordnung nach einem der vorhergehenden Ansprüche, wobei das Substrat ein Halbleiterwafer ist.

8. Mikromechanisches Verfahren zum Bonden von Halbleitersubstraten mit den Schritten:
Erwärmen einer Anordnung nach einem der vorhergehenden Ansprüche über den Schmelzpunkt der Bondlegierung; und
Bonden der erwärmten Anordnung auf ein weiteres Halbleitersubstrat unter Druck, wobei ein Teil der Schmelze der Bondlegierung zum Stopprahmen (7; 7a, 7b; 7b'; 70) fließt und dort bei einem Auftreffen auf den Stopprahmen (7; 7a, 7b; 7b'; 70) erstarrt, ohne zum Funktionsbereich (4) zu gelangen.

9. Gebondeter Halbleiterchip mit:
einer ersten Chiphälfte (1) mit einem Funktionsbereich (4) und einen den Funktionsbereich (4) umgebenden Randbereich (4a);
wobei im Randbereich (4a) beabstandet vom Funktionsbereich (4) ein Bondrahmen (2) aus einer Bondlegierung aus mindestens zwei Legierungskomponenten vorgesehen ist; und einer zweiten Chiphälfte (10), welcher eine Bondfläche (BF) aufweist, auf die der Bondrahmen (2) gebondet ist.
wobei innerhalb des vom Bondrahmen (2) umgebenen Teils (4a2) des Randbereichs (4a) zwischen dem Bondrahmen (2) und dem Funktionsbereich (4) mindestens ein Stopprahmen (7;7a;7b;7b';70) vorgesehen ist, **dadurch gekennzeichnet, dass** der Stopprahmen (7;7a;7b;7b';70) aus mindestens einer der Legierungskomponenten besteht, derart, dass bei einem Auftreffen einer Schmelze der Bondlegierung beim Bonden auf den Stopprahmen (7;7a;7b;7b';70) ein Erstarren der Bondlegierung auftritt.

10. Gebondeter Halbleiterchip nach Anspruch 9, wobei es einen Bereich (27) erstarrter Bondlegierung gibt, der zwischen dem Bondrahmen (2) und Stopprahmen (7; 7a, 7b; 7b'; 70) verläuft.

## Claims

1. Assembly for bonding semiconductor substrates comprising:
a semiconductor substrate having a chip pattern having a multiplicity of semiconductor chips (1) each having a functional region (4) and an edge region (4a) surrounding the functional region (4);
wherein a bonding frame (2) composed of a bonding alloy composed of at least two alloy components is provided in the edge region (4a) at a distance from the functional region (4);
and at least one stop frame (7; 7a, 7b; 7b'; 70) is provided within that part (4a2) of the edge region (4a) which is surrounded by the bonding frame (2) between the bonding frame (2) and the functional region (4),
**characterized in that**
the stop frame (7; 7a, 7b; 7b'; 70) consists of at, least one of the alloy components, in such a way that, when a melt of the bonding alloy impinges on the stop frame (7; 7a, 7b; 7b'; 70) during bonding, solidification of the bonding alloy occurs.

2. Assembly according to Claim 1, wherein two stop frames (7; 7a, 7b; 7b'; 70) each composed of at least one of the alloy components are provided between the bonding frame (2) and the functional region (4), said stop frames running substantially parallel and forming an interspace (Z).

3. Assembly according to Claim 1 or 2, wherein the bonding frame (70) has a pattern structure composed of discrete pattern elements (70a, 70b, 70c, 70d) with a respective intermediate distance (d).

4. Assembly according to any of the preceding claims, wherein at least one further stop frame (7a') composed of at least one of the alloy components is provided in the edge region (4a) within that part (4a1) of the edge region (4a) which is not surrounded by the bonding frame, said at least one further stop frame being designed in such a way that, when a melt of the bonding alloy impinges on the further stop frame (7a') during bonding, solidification of the bonding alloy occurs.

5. Assembly according to any of the preceding claims, wherein the bonding alloy has a eutectic composition.

6. Assembly according to any of the preceding claims, wherein the bonding alloy consists of one of the following mixtures: Au-Si, Al-Ge, Cu-Sn, Au-In and alloys composed of the respective individual materials under consideration, such as e.g. AlSiCu-GE, AlSi-Ge or AlCu-Ge.

7. Assembly according to any of the preceding claims, wherein the substrate is a semiconductor wafer.

8. Micromechanical method for bonding semiconductor substrates comprising the following steps:
heating an assembly according to any of the preceding claims above the melting point of the bonding alloy; and
bonding the heated assembly on to a further semiconductor substrate under pressure, wherein part of the melt of the bonding alloy flows to the stop frame (7; 7a, 7b; 7b'; 70) and solidifies there when it impinges on the stop frame (7; 7a, 7b; 7b'; 70), without reaching the functional region (4).

9. Bonded semiconductor chip comprising:
a first chip half (1) having a functional region (4) and an edge region (4a) surrounding the functional region (4);
wherein a bonding frame (2) composed of a bonding alloy composed of at least two alloy components is provided in the edge region (4a) at a distance from the functional region (4);
and a second chip half (10), which has a bonding surface (BF), onto which the bonding frame (2) is bonded,
wherein at least one stop frame (7; 7a, 7b; 7b'; 70) is provided within that part (4a2) of the edge region (4a) which is surrounded by the bonding frame (2) between the bonding frame (2) and the functional region (4),
**characterized in that**
the stop frame (7; 7a, 7b; 7b'; 70) consists of at least one of the alloy components, in such a way that, when a melt of the bonding alloy impinges on the stop frame (7; 7a, 7b; 7b'; 70) during bonding, solidification of the bonding alloy occurs.

10. Bonded semiconductor chip according to Claim 9, wherein there is a region (27) of solidified bonding alloy which runs between the bonding frame (2) and stop frame (7; 7a, 7b; 7b'; 70).

## Revendications

1. Agencement pour l'assemblage de substrats semi-conducteurs, avec:
un substrat semi-conducteur avec un motif de puces comprenant une pluralité de puces semi-conductrices (1), qui présentent respectivement une zone fonctionnelle (4) et une zone marginale (4a) entourant la zone fonctionnelle (4),
dans lequel il est prévu, dans la zone marginale (4a) à distance de la zone fonctionnelle (4), un cadre d'assemblage (2) en un alliage d'assemblage comprenant au moins deux composants d'alliage;
et il est prévu, à l'intérieur de la partie (4a2) de la zone marginale (4a) entourée par le cadre d'assemblage (2), entre le cadre d'assemblage (2) et la zone fonctionnelle (4), au moins un cadre d'arrêt (7; 7a; 7b; 7b'; 70),
**caractérisé en ce que** le cadre d'arrêt (7; 7a; 7b; 7b'; 70) se compose d'au moins un des composants d'alliage, de telle manière que, lorsque du bain fondu de l'alliage d'assemblage lors de l'assemblage atteint le cadre d'arrêt (7; 7a; 7b; 7b'; 70), il se produise une solidification de l'alliage d'assemblage.

2. Agencement selon la revendication 1, dans lequel il est prévu entre le cadre d'assemblage (2) et la zone fonctionnelle (4) deux cadres d'arrêt (7; 7a, 7b; 7b'; 70) respectivement composés d'au moins un des composants d'alliage, qui sont essentiellement parallèles et qui forment un espace intermédiaire (Z).

3. Agencement selon la revendication 1 ou 2, dans lequel le cadre d'assemblage (70) présente une structure de motif en éléments de motif discrets (70a, 70b, 70c, 70d) avec une distance intermédiaire (d) respective.

4. Agencement selon l'une quelconque des revendications précédentes, dans lequel il est prévu dans la zone marginale (4a), à l'intérieur de la partie (4a1) de la zone marginale (4a) non entourée par le cadre d'assemblage, au moins un autre cadre d'arrêt (7a') composé d'au moins un des composants d'alliage, qui est configuré de telle manière que, lorsque du bain fondu de l'alliage d'assemblage lors de l'assemblage atteint l'autre cadre d'arrêt (7a'), il se produise une solidification de l'alliage d'assemblage.

5. Agencement selon l'une quelconque des revendications précédentes, dans lequel l'alliage d'assemblage présente une composition eutectique.

6. Agencement selon l'une quelconque des revendications précédentes, dans lequel l'alliage d'assemblage se compose d'au moins un des mélanges suivants: Au-Si, Al-Ge, Cu-Sn, Au-In ainsi que d'alliages des matériaux individuels respectifs en question, comme par exemple AlSiCu-Ge, AlSi-Ge ou AlCu-Ge.

7. Agencement selon l'une quelconque des revendications précédentes, dans lequel le substrat est une galette de semi-conducteur.

8. Procédé micromécanique pour l'assemblage de substrats semi-conducteurs, comprenant les étapes suivantes:
chauffage d'un Agencement selon l'une quelconque des revendications précédentes au-delà du point de fusion de l'alliage d'assemblage, et
assemblage de l'agencement chauffé sur un autre substrat semi-conducteur sous pression, dans lequel une partie du bain fondu de l'alliage d'assemblage s'écoule vers le cadre d'arrêt (7; 7a, 7b; 7b'; 70) et s'y solidifie lorsqu'elle atteint le cadre d'arrêt (7; 7a, 7b; 7b'; 70) sans parvenir à la zone fonctionnelle (4).

9. Puce semi-conductrice assemblée, avec:
une première moitié de puce (1) avec une zone fonctionnelle (4) et une zone marginale (4a) entourant la zone fonctionnelle (4);
dans laquelle il est prévu dans la zone marginale (4a), à distance de la zone fonctionnelle (4), un cadre d'assemblage (2) en un alliage d'assemblage comprenant au moins deux composants d'alliage;
et une deuxième moitié de puce (10), qui présente une face d'assemblage (BF), sur laquelle le cadre d'assemblage (2) est assemblé,
dans laquelle il est prévu, à l'intérieur de la partie (4a2) de la zone marginale (4a) entourée par le cadre d'assemblage (2), entre le cadre d'assemblage (2) et la zone fonctionnelle (4), au moins un cadre d'arrêt (7; 7a; 7b; 7b'; 70),
**caractérisée en ce que** le cadre d'arrêt (7; 7a; 7b; 7b'; 70) se compose d'au moins un des composants d'alliage, de telle manière que, lorsque du bain fondu de l'alliage d'assemblage lors de l'assemblage atteint le cadre d'arrêt (7; 7a; 7b; 7b'; 70), il se produise une solidification de l'alliage d'assemblage.

10. Puce semi-conductrice assemblée selon la revendication 9, dans laquelle il se trouve une zone (27) d'alliage d'assemblage solidifié, qui s'étend entre le cadre d'assemblage (2) et le cadre d'arrêt (7; 7a, 7b; 7b'; 70).
